# EUROPEAN PATENT APPLICATION

(11) **EP 3 324 107 A1**
(43) Date of publication of application: **23.05.2018**
(21) Application number: 17382757.7
(22) Date of filing: 09.11.2017
(51) Int. Cl.: F21S 43/19, F21S 43/14, B60Q 1/26, B60Q 1/30, B60Q 1/22, H01L 25/075

(54) **SIGNALLING MODULE FOR A VEHICLE**

(30) Priority: 10.11.2016 ES 201631427
(71) Applicant: Seat, S.A., 08760 Martorell (ES)
(72) Inventor: CORULL MASSANA, ERNEST, 08760 MARTORELL (ES); HUPEL, MARTIN, 08760 MARTORELL (ES); PAREDES DOMINGUEZ, MAGNOLIA, 08760 MARTORELL (ES); PUIGDELLIVOL GUIXE, FERRAN, 08760 MARTORELL (ES); LAGRESA PALMA, ISABEL, 08760 MARTORELL (ES)
(74) Representative: Isern Patentes y Marcas S.L.

(57) **Abstract**

A signalling module (1) for a vehicle (8) in which the vehicle (8) has at least two tail lights (7) arranged in a rear zone of the vehicle (8), in which the signalling module (1) includes at least one first light emitter (31), in which the at least one first light emitter (31) is designed to generate a first function, at least one second light emitter (32), in which the at least one second light emitter (32) is designed to generate a second function, in which the first function is generated by the signalling module (1) and the second function is generated by the signalling module (1), where the signalling module (1) is arranged on one of the at least two tail lights (7). This enhances design freedom for the tail lights, as well as reducing costs by sharing components between different functions.

## Description

### PURPOSE OF THE INVENTION

The present patent application relates to a signalling module for a vehicle according to Claim 1, incorporating notable innovations and advantages.

### BACKGROUND TO THE INVENTION

The automobile sector is continuously looking for ways to create synergies between the components carried on a vehicle. More specifically, efforts are made to use parts for multiple functions or to make parts modular so that same can be used in different vehicle models. Thus, in the field of lighting, lighting modules are for example used for rear signalling in the presence of fog, also known as rear fog lights. Said light module can be placed in different lights or tail lights of different vehicle models, thereby increasing the production volume of same, increasing assembly synergies, and reducing associated costs.

Specifically, two tail lights in which each tail light includes a lighting unit, in which each lighting unit is able to generate two signalling functions, for example fog lights and reversing lights, are known from the prior art, specifically the document DE102009052321. A printed circuit board is included to support, control and power the LEDs.

The invention according to said patent application is intended to improve the related design, minimizing the space or volume occupied by the signalling functions such as reversing lights or fog lights. Same includes a first group of LEDs positioned at the focus of the ellipse of the reflectors. Said LEDs are red and of greater intensity, and provide the fog lighting function. A second group of LEDs is arranged off-centre in relation to the focus of the ellipse of the reflectors. Said LEDs are white and provide the reverse-lighting function. The invention includes shared reflectors for different LEDs. The priority for the light is the fog light function.

A shared module used to carry out two different functions is also known from the prior art, as reflected in document FR2928616. Each module performs a different function but shares most of the related components, as well as an exterior design.

The invention according to said application is intended to ensure that the design of the vehicle is not asymmetrical. To do so, a shared module for reversing lights and rear fog lights is assembled on each side of the vehicle. Despite sharing parts and having the same external design, each module performs a different function. Thus, the reversing light focuses all of the light from the shared light emitter towards the central output, and is white. A filter is added for the rear fog light such that red light is emitted over the entire surface. As shown, there is still at least one different component for performing each of the functions required.

Furthermore, other documents are known in which two lighting functions are combined in a single module, without in any case reducing the number of modules used in the vehicle, maintaining photometric characteristics of the emitted light that are entirely valid for the signalling functions to be performed.

Consequently, there is an evident need for a signalling module for a vehicle that increases design freedom for the tail lights of the vehicle, while reducing costs by increasing the number of shared parts for implementation of various different functions.

### DESCRIPTION OF THE INVENTION

The present invention comprises a single signalling module of a vehicle that, when installed in one of the tail lights of the vehicle, is able to perform two different signalling functions. By way of example, said signalling functions may be signalling for reversing or signalling for fog, also known as reversing lights and fog lights respectively. The objective of the present invention is to minimize the components and the space used to perform said functions. Thus, the resulting reduction in size improves transportation logistics, assembly and the space occupied, enabling firstly a reduction in costs and secondly more space available for primary signalling functions in the respective tail lights.

This is intended to maximize the volume or space available to perform the main rear signalling and lighting functions, such as brake lights, the signalling of the lights in an illuminated state, etc., which have a significant impact on vehicle design. Conversely, the invention is intended to minimize the volume or space occupied by secondary lighting functions, such as fog light signalling, reverse gear signalling, indicator activation signalling, etc. while reducing both product and assembly costs for these lighting functions.

Accordingly and more specifically, the invention relates to a signalling module for a vehicle in which the vehicle has at least two tail lights arranged in a rear zone of the vehicle, in which the signalling module includes at least one first light emitter, in which the at least one first light emitter is designed to generate a first function, at least one second light emitter, in which the at least one second light emitter is designed to generate a second function, in which the first function is generated by the signalling module and the second function is generated by the signalling module, where the signalling module is arranged on one of the at least two tail lights. This provides a single module able to integrate two different lighting functions. Said module reduces the space occupied and reduces costs, both for the parts used to build same and in terms of assembly time.

"Rear zone" shall mean the rearmost zone of the vehicle in consideration of the direction of forward movement of the vehicle. "Tail light" shall mean, without limitation, any light located on the rear of the vehicle, which may be a static tail light, a movable tail light that is moved when the tailgate is opened, or the third brake light. It should be noted that, despite being two secondary functions in terms of the design of a light, it is desirable that said functions occupy as little space as possible in the tail light of a vehicle, thereby freeing up more space for the rest of the functions, which are more important in terms of visibility for a third vehicle, and more significant aesthetically on account of the volume and surface area of the light or tail light that they occupy.

In a first preferred embodiment of the invention, the first function is a signalling of an activation of reverse light (RM). In this way, the reverse-gear signalling light, or reversing light, can be incorporated with another function, thereby optimizing cost and space relating to the tail light.

In a second preferred embodiment of the invention, the second function is a signalling of an activation of a fog light or rear fog light (RN). In this way, the fog-light signalling light, or fog light or rear fog light, can be incorporated with another function, thereby optimizing cost and space relating to the tail light.

Alternatively, the first function and/or the second function may be a different signalling function provided in the rear portion of the vehicle, such as signalling of activation of an indicator, signalling of activation of dipped-beam headlights, signalling of activation of the brake pedal, signalling of actuation of the handbrake or any other signalling function performed in the rear portion of the vehicle.

According to another aspect of the invention, the signalling module includes an optical element, in which said optical element includes at least one first optical means and at least one second optical means, in which the at least one first optical means face the at least one first light emitter and the at least one second optical means face the at least one second light emitter. Consequently, each signalling function has specific optical means in accordance with the related specific lighting requirements. In terms of lighting, there are no reflections on a reflective surface, which conversely can be found in the documents relating to the prior art. The solution according to the present invention is simpler in terms of calculating surface areas (diffusion and refraction) and occupies much less space. Advantageously, the optical element is obtained from a single injection. Thus, the at least one first optical means and the at least one second optical means are obtained in a single production stage or process, simplifying the number of components and the complexity of the signalling module according to the present invention.

In a preferred embodiment of the invention, the at least one first light emitter is substantially white, the at least one second light emitter is substantially red, and the optical element is transparent. This makes it possible to satisfy the requirement to emit white light for the reversing lights (RM) and red light for the fog lights or rear fog lights (RN). This obviates the need for colour filters or additional interposed elements, and accordingly the optical performance is increased along with the simplicity of the component parts. Alternatively, the colour of the at least one first light emitter or of the at least one second light emitter may be different, depending on the signalling function to be performed.

Advantageously, the at least one first light emitter includes at least one substantially white high-power LED and the at least one second light emitter includes at least one substantially red high-power LED. This helps to reduce the space occupied by the light emitters, satisfying photometry requirements or the light emission requirements depending on the approval conditions for said light or tail light.

According to another preferred embodiment of the invention, the at least one first optical means include at least one first Fresnel lens and at least one first optical lens, and the at least one second optical means include at least one second Fresnel lens and at least one second optical lens. This obviates the need for reflectors for the signalling module according to the invention, the light being handled directly. In the context of the present patent application, a Fresnel lens is considered to be the same as a collimator, i.e. a system that uses a diverging beam (of light, of electrons, etc.) to obtain a parallel "beam" of rays of light having the same properties. Moreover, lenses or optical lens shall mean any entity able to divert rays of light, including converging, diverging, artificial and any other type of lenses.

According to another aspect of the invention, the signalling module according to the present invention includes a printed circuit board, in which the printed circuit board includes at least one electronic component designed to perform the first function and in which the printed circuit board includes at least one electronic component designed to perform the second function, such that the first function and the second function share the same printed circuit board. The shared printed circuit board helps to significantly reduce the cost of the module.

Advantageously, the printed circuit board includes at least one controller, in which the at least one controller interacts with the at least one first light emitter, and in which the at least one controller interacts with the at least one second light emitter, such that the at least one controller activates either the at least one first light emitter or the at least one second light emitter. Said controller activates either the at least one first light emitter or the at least one second light emitter exclusively and not simultaneously. This ensures that light is emitted for each function in accordance with approval requirements, with no light interference between the plurality of functions. In a preferred embodiment, the printed circuit board includes a controller, thereby reducing the number of components used.

More specifically, the activation of the at least one first light emitter takes precedence over the activation of the at least one second light emitter. In other words, if there is an activation instruction for the first light emitter, the second light emitter remains deactivated, even in the event of a corresponding activation instruction. This ensures that there is no interference between the plurality of light emission functions.

Advantageously, the printed circuit board includes electrical power control means, in which the electrical power control means are of the switched type. "Electrical power control means" shall be understood to mean "driver", which is used commonly in the field of electronics. The advantage of such electrical power control means or switched driver is that less energy is consumed and the size of the sink is minimized. The use of switched electrical power control means ensures that the at least one first light emitter and the at least one second light emitter are partially deactivated, and preferably deactivated half of the time. The application of a high frequency of activations and deactivations applied by the switched electrical power control means is imperceptible to the human eye, but at thermal level means that less energy is released by the at least one first light emitter and by the at least one second light emitter. Consequently, the size of the sink required is smaller, making the signalling module according to the present invention smaller. Furthermore, the use of switched electrical power control means also means that the energy generated by the driver or controller is also lower, also helping to reduce the size of the energy sink required.

Only one such electrical power control means or driver is used and the output of same is PWM, a term commonly used in the field of electronics. It should also be noted that said electrical power control means or driver is the most expensive shared component of the printed circuit board. Said component is particularly important when the lighting is provided by LED, in consideration of the sensitivity of LEDs to power alterations. Accordingly, said driver is vital to keep the electrical voltage constant, which keeps the light flow (intensity and colour) and the temperature of the lamp stable. The heat generated by the LED lamp needs to be taken into consideration since the correct management thereof optimizes the service life of the LED emitter. Thus, it is essential for the driver to establish the input power to the LEDs.

According to another aspect of the invention, the signalling module according to the invention includes an energy sink, in which the energy sink extracts energy substantially equal to the energy produced by the at least one first light emitter or the at least one second light emitter. Said energy sink can also extract energy from other components of the signalling module, such as the driver or the electrical power control means. It can therefore be seen that, as a result of the fact that the at least one first light emitter is not activated simultaneously with the at least one second light emitter, the energy sink only needs to be dimensioned for the energy released by the at least one first light emitter or the at least one second light emitter. Thus, advantageously, the energy sink need not be dimensioned to extract the energy generated by the at least one first light emitter and the at least one second light emitter operating simultaneously. This reduces the dimensions of the energy sink required.

In a specific embodiment, a shared energy sink can be used, given that the two lighting functions never operate simultaneously. Otherwise, a larger or more efficient sink would be required, such as the use of forced convection. As a result, it has been possible to design the energy sink with sufficient capacity to remove heat only from one of the two functions, the least favourable of the two functions in terms of heat energy generated. Since under no circumstances do the two functions operate simultaneously, the dimensions and capacity for the transmission of heat energy can be determined for a single function, enabling the dimensions of the component to be reduced.

According to another aspect of the invention, one of the at least two tail lights of the vehicle includes a cover, in which the cover is substantially transparent, and in which the outer cover faces the signalling module. The cover or shade is arranged in the outer zone of the tail light and performs a protection function against impacts and an insulation function against environmental conditions.

According to another aspect, the invention relates to a vehicle that includes a tail light with the lighting module as described above, in which the tail light is preferably arranged on the driver's side, which improves rear visibility.

It should be noted that, in the preferred embodiment, the first function is a signalling of an activation of reverse gear and the second function is a signalling of activation of a fog light, prevailing approval requirements or standards requiring there to be at least one signalling element for activation of the fog lights in the rear zone of the vehicle, and more specifically on the driver's side. With regard to signalling of activation of reverse gear, there are no positional restrictions. Currently, as shown in the prior art discussed, the signalling for activation of a fog light on the driver's side and the signalling of activation of reverse gear at least on the passenger side are installed. This ensures symmetry in the design.

It should be noted that, advantageously, the present invention discloses the use of a single signalling module installed in a tail light of the vehicle, specifically in the tail light on the driver's side, that is able to perform two different signalling functions, thereby maximizing the number of shared components and occupying a minimum amount of space within the tail light of the vehicle. Performing both functions in a single module helps to reduce costs, assembly time and the attachment means used.

The attached drawings show, by way of a nonlimiting example, a signalling module for a vehicle according to the invention. Other features and advantages of said signalling module for a vehicle to which the present invention relates are set out in the description of a preferred, but non-exclusive, embodiment, which is illustrated by way of a nonlimiting example in the attached drawings, in which:

### SHORT DESCRIPTION OF THE FIGURES

Figure 1A is an elevation of the signalling module for a vehicle according to the present invention.
Figure 1B is a profile view of the signalling module for a vehicle according to the present invention.
Figure 1C is a plan view of the signalling module for a vehicle according to the present invention.
Figure 2 is a rear view of a vehicle with the signalling module for a vehicle according to the present invention.
Figure 3 is a schematic representation of the components of the signalling module for a vehicle according to the present invention.

### DESCRIPTION OF A PREFERRED EMBODIMENT

In consideration of the numbering adopted, the aforementioned figures show an example preferred embodiment of the invention that includes the parts and elements mentioned and described in detail below.

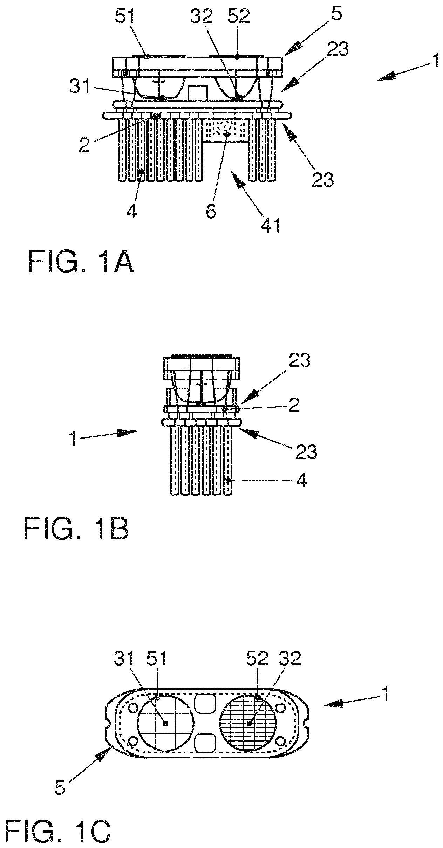

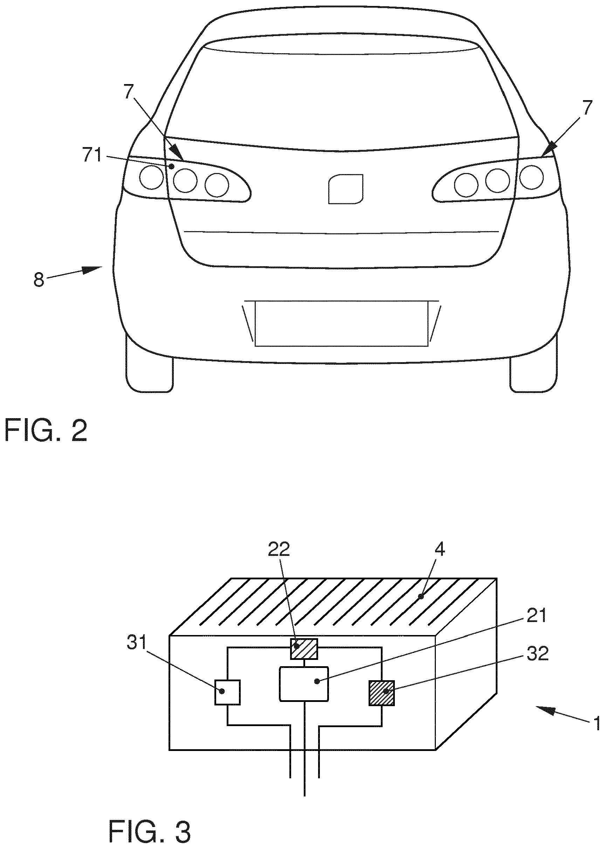

As shown in Figures 1A, 1B, 1C and 2, the present invention relates to a signalling module 1 for a vehicle 8 in which the vehicle 8 has at least two tail lights 7 arranged in a rear zone of the vehicle 8, in which the signalling module 1 includes at least one first light emitter 31, in which the at least one first light emitter 31 is designed to generate a first function; at least one second light emitter 32, in which the at least one second light emitter 32 is designed to generate a second function; in which the first function is generated by the signalling module 1 and the second function is generated by the signalling module 1, where the signalling module 1 is arranged on one of the at least two tail lights 7.

The present invention is intended to optimize use of the synergies between the components that perform the first function and the components that perform the second function.

Henceforth, reference shall be made to a preferred embodiment of the invention. Thus, the first function is a signalling of an activation of reverse gear (RM). The second function is a signalling of an activation of a fog light or rear fog light (RN).

According to the specific regulatory and operational requirements for these two specific functions, and also in accordance with the architectural requirements of the vehicle, the signalling module according to the present invention makes it possible to activate only one of the two functions at any given time, which makes it possible to use various components without having to duplicate same, such as a current driver or electrical power control means 21, a printed circuit board 2 and the assembly process thereof, a radiator or sink 4, and optics for treating light beams emitted, integrating same into a single optical element 5.

More specifically and as shown in Figures 1A, 1B, 1C and 2, the first function is a signalling of activation of reverse gear.

Furthermore and as shown in Figures 1A, 1B, 1C and 2, the second function is a signalling of activation of a fog light.

According to a preferred embodiment of the invention and as shown in Figures 1A, 1B and 1C, the signalling module 1 includes an optical element 5, in which the optical element 5 includes at least one first optical means 51 and at least one second optical means 52, in which the at least one first optical means 51 face the at least one first light emitter 31 and the at least one second optical means 52 face the at least one second light emitter 32.

As shown in Figure 1A, the optical means are built as a single part: the optical element 5, although the two optics are kept separate and independent. Specifically, the optical element 5 or a light treatment component is made of a transparent plastic that is essentially rectangular and stands on a printed circuit board (PCB) 2 via four legs.

More specifically and as shown in Figure 2, the at least one first light emitter 31 is substantially white, the at least one second light emitter 32 is substantially red, and the optical element 5 is transparent.

Additionally and as shown in Figure 1C, the at least one first light emitter 31 includes at least one substantially white high-power LED and the at least one second light emitter 32 includes at least one substantially red high-power LED. "High power" shall be understood to mean a power supply of at least 0.5 amps.

According to another aspect of the invention and as shown in Figures 1A and 1B, the at least one first optical means 51 include at least one first Fresnel lens and at least one first optical lens, and the at least one second optical means 52 include at least one second Fresnel lens and at least one second optical lens.

As previously mentioned, Fresnel lens shall be understood to be the same as a collimator. Moreover, in a preferred embodiment, the optical element 5 is essentially rectangular and stands via four points on the printed circuit board 2.

As shown in Figures 1A and 1B, a first light emitter (31) faces the first optical means 51. Furthermore, the second light emitter (32) faces the second optical means 52. Consequently, the two light treatments are independent, albeit performed using a single part: optical element 5.

Thus, more specifically, the Fresnel lens, which is used to collimate the light rays, i.e. to turn the cone of light emitted by the LED into parallel beams of light, specifically parallel to the heat sink 4. Subsequently, the parallel beams of light enter the respective optics which makes it possible to open the field and range of light required to achieve a given photometry in accordance with the related function.

More specifically and as shown in Figure 3, the signalling module 1 includes a printed circuit board 2, in which the printed circuit board 2 includes at least one electronic component designed to perform the first function and in which the printed circuit board 2 includes at least one electronic component designed to perform the second function.

It should be noted that the electronics and the printed circuit board 2 of the signalling module 1 constitute a shared element. This significantly reduces the cost of said signalling module 1. Furthermore and as shown in Figure 1A showing the side view of the module, the hollow shown in the energy sink 4 is an electrical connector. The signalling module 1 is powered via the rear of the printed circuit board 2 since this facilitates the positioning of a seal about the printed circuit board (PCB) 2, thereby easily sealing same, with the minor drawback of requiring a double-sided printed circuit board (PCB) 2 (with electronics on both sides).

According to another aspect of the invention and as shown in Figure 3, the printed circuit board 2 includes a controller 22, in which the controller 22 interacts with the at least one first light emitter 31, and in which the controller 22 interacts with the at least one second light emitter 32, such that the controller 22 activates either the at least one first light emitter 31 or the at least one second light emitter 32.

According to a preferred embodiment of the invention and as shown in Figure 3, the activation of the at least one first light emitter 31 takes precedence over the activation of the at least one second light emitter 32.

Thus, when in operation, reversing lights RM take precedence over fog lights RN according to the attached table. This is because reverse gear RM is activated for less time, and as such takes precedence. The table below shows the decision taken by the controller 22 relating to the function to be activated, depending on the initial activation state of reversing lights RM and fog lights RN, where ON means that the related function is activated and OFF that the respective function is deactivated:

| RM | RN | Decision |
|---|---|---|
| ON | OFF | RM |
| OFF | ON | RN |
| ON (1) | ON (2) | RM |
| ON (2) | ON (1) | RM |

(1) Means that said function has been activated first
(2) Means that said function is activated while (1) is activated
As shown, reversing lights RM take precedence in all cases, except where reversing lights RM do not need to be activated.

More specifically and as shown in Figure 3, the printed circuit board 2 includes electrical power control means 21, in which the electrical power control means 21 are switched.

It should be noted that, as shown in Figures 1A, 1B and 3, the signalling module 1 includes an energy sink 4, in which the energy sink 4 extracts energy substantially equal to the energy produced by the at least one first light emitter 31 or the at least one second light emitter 32.

As mentioned previously, the printed circuit board 1 is double sided, i.e. with electronics on both sides. An electrical connector 6 is connected to the rear face of the printed circuit board 1. Rear face means the face opposite the face with the controller 22 and the LEDs or light emitters 31, 32. The energy sink 4 has a hollow 41 in which the electrical connector 6 is positioned.

According to another aspect of the invention and as shown in Figures 1C and 2, one of the at least two tail lights 7 includes a cover 71, in which the cover 71 is substantially transparent, and in which the outer cover 71 faces the signalling module 1. The signalling module 1 includes a shade or cover 71 arranged in the outer zone of the tail light or light.

Furthermore and as shown in Figure 2, the invention relates to a vehicle 8 that includes a tail light 7 with the lighting module 1 as described above, in which the tail light 7 is arranged on the driver's side. This provides a signalling module 1 that is able to fully perform two independent signalling functions without requiring any additional light sources. Furthermore and advantageously, the dimensions of said module are reduced and the number of synergies between components is maximized, such as to reduce the number of components used in the present signalling module.

The tail light 7 or light includes a plastic shade as an outer element designed to protect the internal components of the signalling module. Said plastic shade is preferably transparent.

The details, forms, dimensions and other additional elements, as well as the components used to implement the signalling module for a vehicle light may be replaced using other such appropriate elements that are technically equivalent, without thereby departing essentially from the invention or the scope defined by the claims included after the list below.

### List of reference signs:

- 1: signalling module
- 2: printed circuit board
- 21: electric power control means
- 22: controller
- 23: face
- 31: first light emitter
- 32: second light emitter
- 4: sink
- 41: hollow
- 5: optical element
- 51: first optical means
- 52: second optical means
- 6: electrical connector
- 7: tail light
- 71: cover
- 8: vehicle

## Claims

1. Signalling module (1) for a vehicle (8), in which the vehicle (8) includes at least two tail lights (7) arranged in a rear zone of the vehicle (8), in which the signalling module (1) includes:
- at least one first light emitter (31), in which the at least one first light emitter (31) is designed to generate a first function,
- at least one second light emitter (32), in which the at least one second light emitter (32) is designed to generate a second function,
**characterized in that** the first function is generated by the signalling module (1) and the second function is generated by the signalling module (1), where the signalling module (1) is arranged on one of the at least two tail lights (7).

2. Signalling module (1) according to Claim 1, **characterized in that** the first function is a signalling of an activation of a reverse gear.

3. Signalling module (1) according to Claim 1, **characterized in that** the second function is a signalling of an activation of a fog light.

4. Signalling module (1) according to Claim 1, **characterized in that** it includes an optical element (5), in which the optical element (5) includes at least one first optical means (51) and at least one second optical means (52), in which the at least one first optical means (51) face the at least one first light emitter (31) and the at least one second optical means (52) face the at least one second light emitter (32).

5. Signalling module (1) according to Claim 4, **characterized in that** the at least one first light emitter (31) is substantially white, **in that** the at least one second light emitter (32) is substantially red, and **in that** the optical element (5) is transparent.

6. Signalling module (1) according to Claim 5, **characterized in that** the at least one first light emitter (31) includes at least one substantially white high-power LED and **in that** the at least one second light emitter (32) includes at least one substantially red high-power LED.

7. Signalling module (1) according to Claim 4, **characterized in that** the at least one first optical means (51) include at least one first Fresnel lens and at least one first optical lens, and **in that** the at least one second optical means (52) include at least one second Fresnel lens and at least one second optical lens.

8. Signalling module (1) according to Claim 1, **characterized in that** it includes a printed circuit board (2), in which the printed circuit board (2) includes at least one electronic component designed to perform the first function and in which the printed circuit board (2) includes at least one electronic component designed to perform the second function.

9. Signalling module (1) according to Claim 8, **characterized in that** the printed circuit board (2) includes at least one controller (22), in which the at least one controller (22) interacts with the at least one first light emitter (31), and in which the at least one controller (22) interacts with the at least one second light emitter (32), such that the at least one controller (22) activates either the at least one first light emitter (31) or the at least one second light emitter (32).

10. Signalling module (1) according to Claim 9, **characterized in that** the activation of the at least one first light emitter (31) takes precedence over the activation of the at least one second light emitter (32).

11. Signalling module (1) according to Claim 8, **characterized in that** the printed circuit board (2) includes electrical power control means (21), in which the electrical power control means (21) are of the switched type.

12. Signalling module (1) according to Claim 1, **characterized in that** it includes an energy sink (4), in which the energy sink (4) extracts energy substantially equal to the energy produced by the at least one first light emitter (31) or the at least one second light emitter (32).

13. Signalling module (1) according to Claim 1, **characterized in that** one of the at least two tail lights (7) includes a cover (71), in which the cover (71) is substantially transparent, and in which the outer cover (71) faces the signalling module (1).

14. Vehicle (8) that includes a tail light (7) with the lighting module (1) according to Claim 1, in which the tail light (7) is arranged on the driver's side.
